# EUROPEAN PATENT APPLICATION

(11) **EP 4 628 624 A1**
(43) Date of publication of application: **08.10.2025**
(21) Application number: 23898331.6
(22) Date of filing: 30.11.2023
(51) Int. Cl.: C23C 16/40, C23C 16/455, C23C 16/50, C07F 5/00, H01L 21/02, H01L 21/285

(54) **PRECURSOR FOR FORMING SCANDIUM- OR YTTRIUM-CONTAINING THIN FILM, METHOD FOR FORMING SCANDIUM- OR YTTRIUM-CONTAINING THIN FILM USING SAME, AND SEMICONDUCTOR DEVICE COMPRISING SCANDIUM- OR YTTRIUM-CONTAINING THIN FILM**

(30) Priority: 30.11.2022 KR 20220163572
(71) Applicant: SK Tri Chem Co., Ltd., Sejong 30068 (KR)
(72) Inventor: OH, Han Sol, Sejong-si 30068 (KR); KIM, Han Byul, Sejong-si 30068 (KR); PARK, Yong Joo, Sejong-si 30068 (KR); NOH, Yun Su, Sejong-si 30068 (KR); LEE, Sang Kyung, Sejong-si 30068 (KR)
(74) Representative: dompatent von Kreisler Selting Werner - Partnerschaft von Patent- und Rechtsanwälten mbB
(86) International application number: PCT/KR2023/019532
(87) International publication number: WO 2024/117807

(57) **Abstract**

The present invention relates to: a precursor, comprising a compound represented by chemical formula 1, for forming a scandium- or yttrium-containing thin film; a method for forming a scandium- or yttrium-containing thin film using same; and a semiconductor device comprising the scandium- or yttrium-containing thin film, wherein the precursor for forming the thin film contains an amidinate ligand and thus can exhibit chemical characteristics of low viscosity, high heat resistance, and high volatility, thereby enabling the formation of a high-quality thin film.

## Description

### Technical Field

The present disclosure relates to a precursor for forming a scandium (Sc) or yttrium (Y) metal-containing thin film, a method for forming a scandium- or yttrium-containing thin film using the same, and a semiconductor device including the scandium- or yttrium-containing thin film. More particularly, the present disclosure relates to a precursor for forming a scandium- or yttrium-containing thin film, the precursor enabling the formation of a high-quality thin film by constructing a precursor with low viscosity, high heat resistance, and high volatility through a chemical structure containing an amidinate ligand, to a method for forming a thin film using the same, and to a semiconductor device including the thin film.

### Background Art

With improved integration density achieved through the miniaturization of line widths in semiconductor devices, there is a limitation in the line width of a space allowed for the implementation of capacitor structures. Accordingly, there have been limitations with existing silicon-based dielectrics in manufacturing methods of semiconductor devices for implementing capacitor structures. In addition, with the application of high-dielectric thin films to replace silicon-based dielectrics, there have been problems in that the leakage current affected by bandgaps is significantly increased, resulting in degradation. As one of the solutions to these problems, a technology for forming high-quality thin films is required, and therefor, precursors used for thin film formation need to be optimized.

To this end, various actinide metal-containing precursors are being developed. For example, Korean Patent Application Publication No. 10-2019-0008427 has disclosed an actinide metal-containing precursor including an aza-allyl ligand, and Korean Patent Application Publication No. 10-2019-0094238 has disclosed an actinide metal-containing precursor including a cyclopentadienyl ligand.

In particular, complex compounds containing cyclopentadienyl groups have lower melting points and higher volatility than compounds containing beta-diketonate or bis(trimethylsilyl)amide and thus are advantageous for use as precursors in thin film formation processes.

For this reason, known technologies, such as Korean Patent No. 10-1660052, Korean Patent Application Publication No. 10-2019-0109142, and Korean Patent Application Publication No. 10-2021-0084297, have proposed chemical structures to which cyclopentadienyl and amidinate ligands are bound, as actinide metal-containing precursors. It has been reported that precursors to which these ligands are bound can improve the disadvantages of existing actinide metal-based precursors with low vapor pressure and high viscosity, and thus are suitable for use in thin film formation processes.

Based on such technologies in the art, the chemical characteristics of precursors are expected to be improved by applying amidinate ligands to metal-containing precursor compounds.

### Disclosure

### Technical Problem

The present disclosure, which has been devised in view of technologies in the art described above, aims to provide a novel precursor for forming a scandium- or yttrium-containing thin film, which is capable of exhibiting suitable chemical characteristics for use as precursors for forming thin films.

In addition, the present disclosure aims to provide a precursor for forming a scandium- or yttrium-containing thin film, which exhibits chemical characteristics such as low viscosity, high heat resistance, and high volatility.

In addition, the present disclosure aims to provide a method for forming a thin film using the above precursor.

In addition, the present disclosure aims to provide a semiconductor device including the above thin film.

### Technical Solution

A precursor for forming a scandium- or yttrium-containing thin film of the present disclosure, which is provided to achieve the objectives as described above, is characterized by including a compound represented by Chemical Formula 1 below.

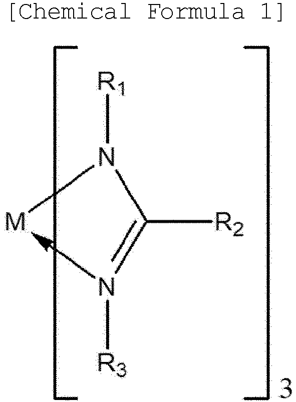

In Chemical Formula 1, M is scandium (Sc) or yttrium (Y), R₁ and R₃ are each independently a straight-chain, branched-chain, or cyclic alkyl or alkenyl group having 1 to 5 carbon atoms, and R₂ is a hydrogen atom or a straight-chain, branched-chain, or cyclic alkyl or alkenyl group having 1 to 6 carbon atoms.

In addition, in Chemical Formula 1, R₂ may be a straight-chain, branched-chain, or cyclic alkyl or alkenyl group having 2 to 4 carbon atoms.

In addition, R₁ and R₃ may each independently be a straight-chain, branched-chain, or cyclic alkyl or alkenyl group having 2 to 5 carbon atoms, and R₂ may be a straight-chain, branched-chain, or cyclic alkyl or alkenyl group having 2 to 4 carbon atoms.

In addition, R1 and R3 may be methyl groups, and R2 may be an isopropyl group.

In addition, R₁ and R₃ may be straight-chain alkyl or alkenyl groups having 1 to 5 carbon atoms.

In addition, R₁ and R₃ may be straight-chain alkyl or alkenyl groups having 1 to 5 carbon atoms, and R₂ may be a straight-chain alkyl or alkenyl group having 1 to 4 carbon atoms.

In addition, R₁ and R₃ may be both the same and may be alkyl or alkenyl groups.

In addition, R₁ and R₃ may be both the same and may be alkyl or alkenyl groups.

In addition, the precursor for forming the thin film may have structures as follows.

In addition, the precursor for forming the thin film may have a viscosity of 60 cP or less and a melting point of 70°C or lower.

In addition, the precursor for forming the thin film may further include a solvent, and the solvent may be one or more of a saturated or unsaturated hydrocarbon having 1 to 16 carbon atoms, a ketone, an ether, glyme, an ester, tetrahydrofuran (THF), and a tertiary amine. In addition, the solvent may be included in an amount range of 1 to 99 wt% with respect to the total weight of the precursor for forming the thin film.

A method for forming a scandium- or yttrium-containing thin film of the present disclosure includes a process of forming a thin film on a substrate using the above precursor for forming the thin film, and the process of forming the thin film on the substrate is characterized by including the following processes: forming a precursor thin film through deposition of the precursor for forming the thin film onto the surface of the substrate, and reacting the precursor thin film with a reactant.

In addition, the process of forming the precursor thin film may include a process of vaporizing the precursor for forming the thin film to transfer the resulting vapor of the precursor into a chamber.

In addition, the deposition may be performed by any one process of spin-on dielectric (SOD) deposition, low-temperature plasma (LTP) deposition, chemical vapor deposition (CVD), plasma enhanced chemical vapor deposition (PECVD), high-density plasma chemical vapor deposition (HDPCVD), atomic layer deposition (ALD), or plasma enhanced atomic layer deposition (PEALD).

In addition, the process of forming the thin film on the substrate may be performed in a temperature range of 150°C to 500°C.

In addition, the reactant may be one or more of nitrogen (N₂), ammonia (NH₃), hydrazine (N₂H₄), nitrous oxide (N₂O), oxygen (O₂), water vapor (H₂O), ozone (O₃), hydrogen peroxide (H₂O₂), silane, hydrogen (H₂), and diborane (B₂H₆).

In addition, the process of forming the scandium- or yttrium-containing thin film on the substrate may include a step of feeding the precursor for forming the thin film onto the substrate and applying a plasma, thereby forming the thin film.

In addition, the scandium- or yttrium-containing thin film of the present disclosure may be formed using the precursor for forming the thin film, and a semiconductor device of the present disclosure is characterized by including a thin film manufactured by the above method for forming the scandium- or yttrium-containing thin film.

### Advantageous Effects

A precursor for forming a scandium- or yttrium-containing thin film, according to the present disclosure, contains an amidinate ligand. Therefore, the precursor compound exhibits characteristics such as excellent structural stability, low viscosity, high volatility, and high heat resistance and thus exhibits physical properties suitable for use in a scandiumor yttrium-containing thin film formation process.

In addition, a high-quality scandium- or yttrium-containing thin film can be formed using the precursor, and a semiconductor device including such a scandium- or yttrium-containing thin film, manufactured by the above thin film formation method, can be provided.

### Description of Drawings

FIG. 1 shows ¹H NMR analysis results of tris(diethyl-n-propylamidinato) yttrium.
FIG. 2 shows TGA results of tris(diethyl-n-propylamidinato) yttrium.
FIG. 3 shows DSC analysis results of tris(diethyl-n-propylamidinato) yttrium.
FIG. 4 shows ¹H NMR analysis results of tris(diethylethylamidinato) yttrium.
FIG. 5 shows TGA results of tris(diethylethylamidinato) yttrium.
FIG. 6 shows ¹H NMR analysis results of tris(di-n-propylethylamidinato) yttrium.
FIG. 7 shows TGA results of tris(di-n-propylethylamidinato) yttrium.
FIG. 8 shows ¹H NMR analysis results of tris(diethyl-n-butylamidinato)yttrium.
FIG. 9 shows TGA results of tris(diethyl-n-butylamidinato)yttrium.
FIG. 10 shows ¹H NMR analysis results of tris(diethyl-n-propylamidinato) scandium.
FIG. 11 shows TGA results of tris(diethyl-n-propylamidinato) scandium.
FIG. 12 shows DSC analysis results of tris(diethyl-n-propylamidinato) scandium.
FIG. 13 shows ¹H NMR analysis results of tris(diethylethylamidinato) scandium.
FIG. 14 shows TGA results of tris(diethylethylamidinato) scandium.
FIG. 15 is a graph showing changes in thin film thickness(thin film deposition rate) as a function of the number of deposition cycles under a process temperature condition of 300°C in a thin film formation process using tris(diethyl-n-propylamidinato)yttrium as a precursor.
FIG. 16 is a graph showing changes in thin film deposition rates (ALD window) by temperatures in a thin film formation process using tris(diethyl-n-propylamidinato) yttrium as a precursor.
FIG. 17 shows XRD analysis results of a thin film deposited under a process temperature condition of 300°C using tris(diethyl-n-propylamidinato)yttrium as a precursor.
FIG. 18 shows XPS analysis results of a thin film deposited under a process temperature condition of 300°C using tris(diethyl-n-propylamidinato)yttrium as a precursor.
FIG. 19 shows measurement results of the dielectric constant and current density for a thin film deposited under a process temperature condition of 300°C using tris (diethyl-n-propylamidinato)yttrium as a precursor.

### Mode for Invention

Hereinafter, the present disclosure will be described in more detail. All terms or words used in the specification and the appended claims should not be construed as being limited to general and dictionary meanings, but will be interpreted based on the meanings and concepts corresponding to the technical ideas of the present disclosure on the basis of the principle that any inventor is allowed to define the terms appropriately for the best explanation.

A precursor for forming a scandium- or yttrium-containing thin film, according to the present disclosure, is characterized by including a compound of Chemical Formula 1 below.

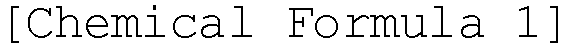

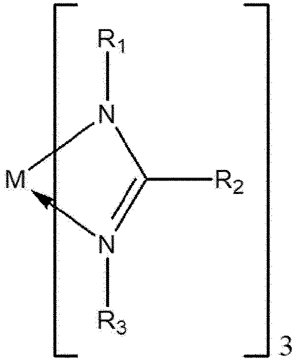

In Chemical Formula 1, M is a scandium or yttrium metal, R₁ and R₃ are each independently a straight-chain, branched-chain, or cyclic alkyl or alkenyl group having 1 to 5 carbon atoms, and R₂ is a hydrogen atom or a straight-chain, branched-chain, or cyclic alkyl or alkenyl group having 1 to 6 carbon atoms.

In the above amidinate ligands, R₁ and R₃ may be the same or different. However, it has been found that R₁ and R₃ containing ligands with the same symmetrical structures are preferable in terms of heat resistance and viscosity.

In addition, while R₂ constituting the amidinate ligand in Chemical Formula 1 may be a hydrogen atom or a straight-chain, branched-chain, or cyclic alkyl or alkenyl group having 1 to 4 carbon atoms, examples thereof preferably include n-alkyl groups, such as an ethyl group, a propyl group, or a butyl group.

The precursor for forming the thin film can form various types of compounds with varying functional groups.

In one embodiment, R₂ in Chemical Formula 1 may be a straight-chain, branched-chain, or cyclic alkyl or alkenyl group having 2 to 4 carbon atoms.

In addition, R₁ and R₃ may each independently be a straight-chain, branched-chain, or cyclic alkyl or alkenyl group having 2 to 5 carbon atoms, and R₂ may be a straight-chain, branched-chain, or cyclic alkyl or alkenyl group having 2 to 4 carbon atoms.

In addition, R₁ and R₃ may be methyl groups, and R₂ may be an isopropyl group.

In addition, R₁ and R₃ may be straight-chain alkyl or alkenyl groups having 1 to 5 carbon atoms.

In addition, R₁ and R₃ may be straight-chain alkyl or alkenyl groups having 1 to 5 carbon atoms, and R₂ may be a straight-chain alkyl or alkenyl group having 1 to 4 carbon atoms.

In addition, R₁ and R₃ may be both the same and may be alkyl or alkenyl groups.

In addition, R₁ and R₃ may be both the same and may be alkyl or alkenyl groups.

In addition, the precursor for forming the thin film may have structures as follows.

The following chemical structures may be illustrated as the precursor for forming the thin film.

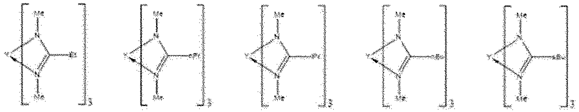

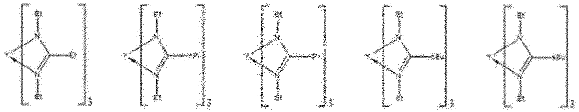

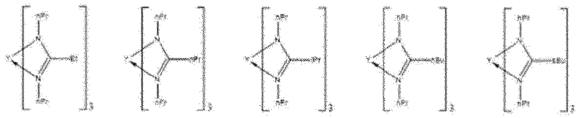

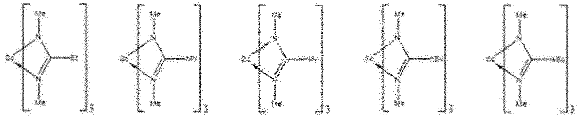

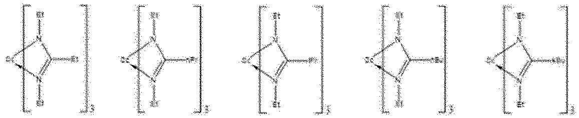

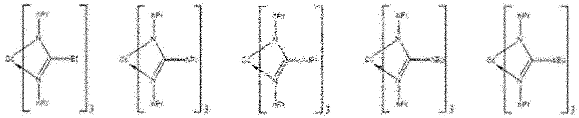

The compound represented by Chemical Formula 1 is a precursor containing the amidinate ligand, in which scandium or yttrium serves as the core metal atom. This precursor may have low viscosity, high thermal stability, high volatility, and a liquid form at room temperature. Therefore, chemical characteristics of the desired precursor can be obtained by synthesizing the ligand-containing precursor.

Specifically, the precursor for forming the thin film may have a viscosity of 60 cP or less and a melting point of 70°C or lower.

The chemical structure of the precursor for forming the thin film enables a liquid precursor with low viscosity, high heat resistance, and high volatility to be obtained, thereby enabling the formation of a high-quality thin film.

In addition, the precursor for forming the thin film of the present disclosure may further include a solvent for dissolving or diluting the precursor compound in consideration of conditions and efficiency of the thin film formation process. As the solvent, any one or a mixture of a saturated or unsaturated hydrocarbon having 1 to 16 carbon atoms, a ketone, an ether, glyme, an ester, THF, and a tertiary amine may be used. Examples of the saturated or unsaturated hydrocarbon having 1 to 16 carbon atoms may include toluene, heptane, and the like, and examples of the tertiary amine may include dimethylethylamine and the like.

In particular, depending on the chemical structure, the precursor compound for forming the thin film may be a solid at room temperature. In this case, by including the solvent, the compound can be dissolved. In other words, when the solvent is included, the solvent has a content enabling the precursor compound to be dissolved and is preferably included in an amount range of 1 to 99 wt% with respect to the total weight of the precursor for forming the thin film.

The precursors with or without the solvent are vaporizable and thus may be fed into a chamber in the form of precursor gas. Therefore, depending on the types of precursor compounds for forming the thin film, the precursor may be present as a liquid at room temperature and, when being easily vaporizable, the thin film formation process may be performed even without involving additional solvents.

In addition, the process of forming the yttrium- or scandium-containing thin film may be performed by any one process of SOD deposition, LTP deposition, CVD, PCVD, HDPCVD, ALD, or PALD.

For example, when being applied, the HDPCVD process may be performed at high vacuum and high power compared to an atmospheric pressure chemical vapor deposition (AP-CVD) process, a low-pressure chemical vapor deposition (LP-CVD) process, or a plasma-enhanced chemical vapor deposition (PECVD) process. Therefore, a thin film that is structurally dense and has excellent mechanical properties can be formed.

To this end, a method for forming a thin film, according to the present disclosure, includes a process of forming a thin film on a substrate using the above precursor for forming the thin film.

Specifically, the process of forming the scandium- or yttrium-containing thin film on the substrate may include the following processes: forming a precursor thin film through deposition of the precursor for forming the thin film onto the surface of the substrate, and reacting the precursor thin film with a reactant.

In addition, for the deposition of the precursor, a process of vaporizing the precursor for forming the thin film to transfer the resulting vapor of the precursor into a chamber may be included.

In addition, the process of forming the scandium- or yttrium-containing thin film on the substrate may include a process of feeding the precursor for forming the thin film onto the substrate and applying a plasma in the presence of the reactant, thereby forming a metal thin film, an oxide thin film, a nitride thin film, an oxynitride thin film, and the like.

The process of forming the thin film may be performed under a condition in an in-chamber pressure range of 1 to 1000 mTorr. In addition, it is suitable that a source power for forming the plasma in the chamber is in the range of 500 to 9,000 W, and a bias power is in the range of 0 to 5,000 W. In addition, the bias power may not be applied in some cases.

In addition, the process of forming the thin film on the substrate may be performed in a temperature range of 150°C to 500°C.

In addition, when feeding the precursor for forming the thin film, a second metal precursor may be introduced as needed to further improve the electrical properties, that is, to improve the capacitance or reduce leakage current values, of the finally formed metal film. As the second metal precursor, a metal precursor including one or more metals (M") selected from silicon (Si), titanium (Ti), germanium (Ge), strontium (Sr), niobium (Nb), barium (Ba), hafnium (Hf), tantalum (Ta), and actinide (Ac) atoms may further be optionally fed. The second metal precursor may be an alkoxybased compound or an alkylamide-based compound including the metal described above. For example, when the metal is Si, SiH(N(CH₃)₂)₃, Si(N(C₂H₅)₂)₄, Si(N(C₂H₅)(CH₃))₄, Si(N(CH₃)₂)₄, Si(OC₄H₉)₄, Si(OC₂H₅)₄, Si(OCH₃)₄, Si(OC(CH₃)₃)₄, and the like may be used as the second metal precursor.

The feeding of the second metal precursor may be performed in the same manner as the feeding of the precursor for forming the thin film. In addition, the second metal precursor may be fed onto the substrate for forming the thin film in conjunction with the precursor or may be fed sequentially after the precursor is completely fed.

The precursor for forming the thin film and, optionally, the second metal precursor described above are preferably kept in a temperature range of 50°C to 250°C and are more preferably kept in a temperature range of 100°C to 200°C, before being fed into the reaction chamber, to be brought into contact with the substrate for forming the thin film.

In addition, after the step of feeding the precursor and before feeding the reactant, a purge process using an inert gas, such as argon (Ar), nitrogen (N₂), or helium (He), in a reactor may be performed to help the precursor and, optionally, the second metal precursor move onto the substrate or allow for the internal pressure of the reactor suitable for deposition and also to remove impurities from the chamber to the outside. In this case, the purge process using the inert gas is preferably performed so that the internal pressure of the reactor is in the range of 1 to 5 Torr.

In addition, as the reactant, one or more of nitrogen (N₂), ammonia (NH₃), hydrazine (N₂H₄), nitrous oxide (N₂O), oxygen (O₂), water vapor (H₂O), ozone (O₃), hydrogen peroxide (H₂O₂), silane, hydrogen (H₂), and diborane (B₂H₆) may be used. When the thin film formation process is performed in the presence of oxidizing gases such as water vapor, oxygen, ozone, and the like described above, a magnesium oxide thin film may be formed. Alternatively, when the thin film formation process is performed in the presence of reducing gases such as hydrogen, ammonia, hydrazine, silane, and the like described above, a pure metal thin film or metal nitride thin film may be formed. In addition, a metal oxynitride thin film may be formed by the combination of the reactants.

Furthermore, a treatment process by heat treatment or light irradiation, in addition to plasma treatment, may be performed. This treatment process is intended to provide heat energy for the deposition of the precursor for forming the thin film and may be performed by methods known in the art. Preferably, to manufacture thin films having the desired physical state and composition at a sufficient growth rate, the treatment process above is preferably performed so that the temperature of the substrate in the reactor is in the range of 100°C to 1,000°C and is preferably in the range of 250°C to 400°C.

In addition, even during the treatment process, a purge process using an inert gas, such as argon (Ar), nitrogen (N₂), or helium (He), in a reactor may be performed to help the reactant move onto the substrate or allow for the internal pressure of the reactor suitable for deposition and also to remove impurities or byproducts from the reactor to the outside, as described above.

The treatment process involving the feeding of the precursor for forming the thin film, feeding of the reactant, and feeding of the inert gas, described above, is considered 1 cycle, and when repeatedly performing 1 or more cycles, the thin film can be formed.

In addition, with the application of the thin film formation process above, various semiconductor devices including the thin film may be manufactured.

### [Synthesis Example 1] Synthesis of tris-(diethyl-n-propylamidinato) yttrium [Y(Et₂nPr-AMD)₃]

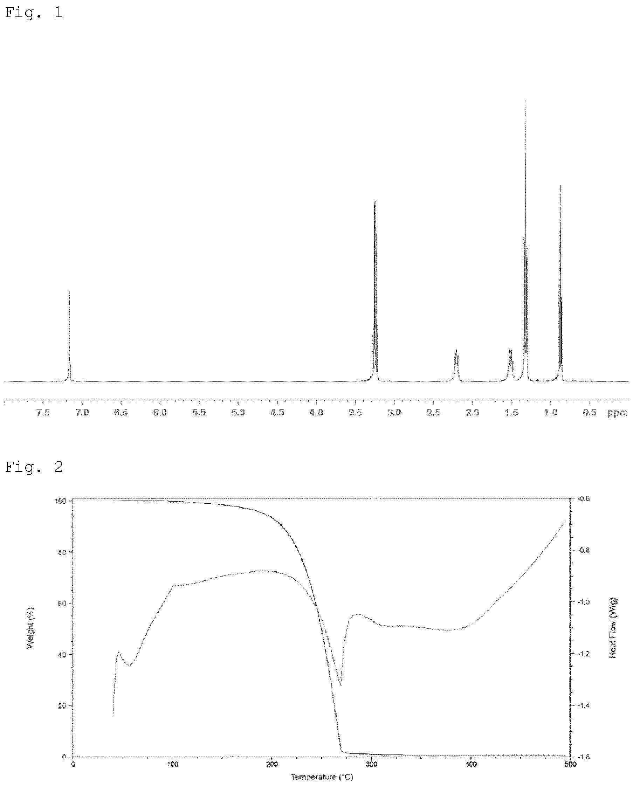

Into 300 mL of THF, 65.57 g (0.4609 mol) of di-n-propylethylamidinate was introduced, followed by cooling the resulting product to a temperature of -78°C, and 184.4 mL (0.4609 mol) of an n-BuLi hexane solution (2.5 M) was then slowly added dropwise to prepare Li-(Et₂nPr-AMD). The resulting solution was stirred at a temperature of -78°C for 30 minutes, heated to room temperature, and then stirred for an additional 2 hours at room temperature. The prepared Li-(Et₂nPr-AMD) solution was slowly added dropwise to a flask containing 30 g (0.4609 mol) of YCl₃ at a temperature of -78°C and then stirred at room temperature for 6 hours. The resulting mixture was evaporated under vacuum, dissolved in 200 mL of pentane, and filtered to evaporate the solvent and volatiles under vacuum to produce a yellow liquid, which was then distilled at a temperature of 156°C and a pressure of 30.1 mTorr to obtain a pale yellow liquid. The yield was 61.10 g (77.6%). The analysis results of NMR (AV400MHz HD, purchased from Bruker) are as shown in FIG. 1, and the characteristic peaks obtained are as follows.

¹H NMR(C₆D₆, 25°C): 0.087(t, 3H), 1.32(t, 6H), 1.52(q, 2H), 2.21(q, 2H), 3.24(q, 4H).

During TGA measurement (SDT Q600, purchased from TA instrument) performed at a temperature rise rate of 10°C/min in a nitrogen atmosphere at a flow rate of 200 mL/min, the pale yellow liquid had a residual mass of 0.1%, indicating that there were almost no residues left. These results are shown in FIG. 2, which demonstrates TGA results showing the percentage of weight loss as a function of temperature changes.

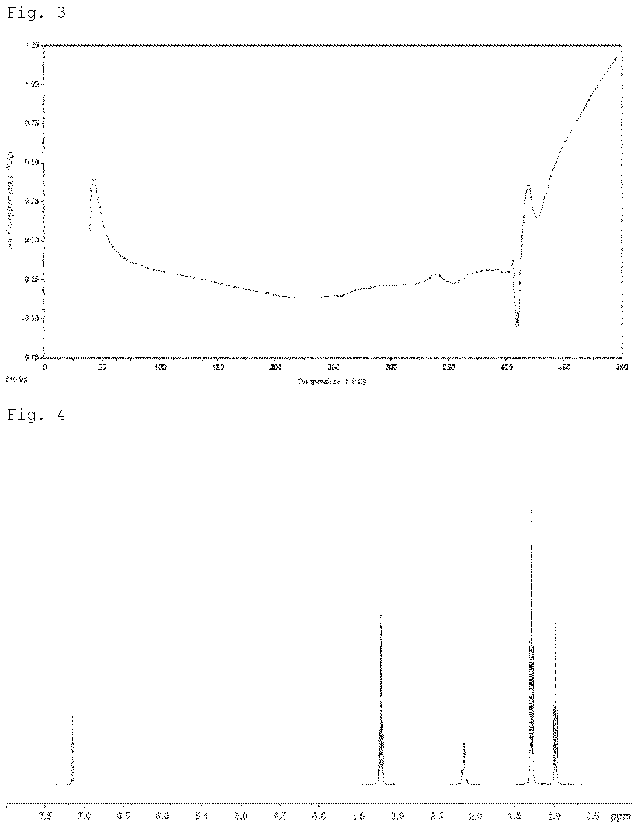

The yellow liquid sample was placed in a sealed container for DSC and kept under a temperature condition of 40°C for 10 minutes, followed by observing a decomposition peak at a temperature of 410°C during DSC analysis measurement (Discovery 25, purchased from TA instrument) performed at a temperature rise rate of 10°C/min. These results are shown in FIG. 3, which demonstrates DSC analysis results showing heat energy changes as a function of temperature changes.

### [Synthesis Example 2] Synthesis of tris-(diethylethylamidinato) yttrium [Y(Et₂Et-AMD)₃]

Into 300 mL of THF, 59.10 g (0.4609 mol) of diethylethylamidinate was introduced, followed by cooling the resulting product to a temperature of -78°C, and 184.4 mL (0.4609 mol) of an n-BuLi hexane solution (2.5 M) was then slowly added dropwise to prepare Li-(Et₂Et-AMD). The resulting solution was stirred at a temperature of -78°C for 30 minutes, heated to room temperature, and then stirred for an additional 2 hours at room temperature. The prepared Li-(Et₂Et-AMD) solution was slowly added dropwise to a flask containing 30 g (0.4609 mol) of YCl₃ at a temperature of -78°C and then stirred at room temperature for 6 hours. The resulting mixture was evaporated under vacuum, dissolved in 200 mL of pentane, and filtered to evaporate the solvent and volatiles under vacuum to produce a yellow liquid, which was then distilled at a temperature of 160°C and a pressure of 30 mTorr to obtain a pale yellow solid. The yield was 52.4 g (72.5%). The analysis results of NMR (AV400MHz HD, purchased from Bruker) are as shown in FIG. 4, and the characteristic peaks obtained are as follows.

¹H NMR (C₆D₆, 25°C): 0.98(t, 3H), 1.29(t, 6H), 2.14(q, 2H), 3.20(q, 4H).

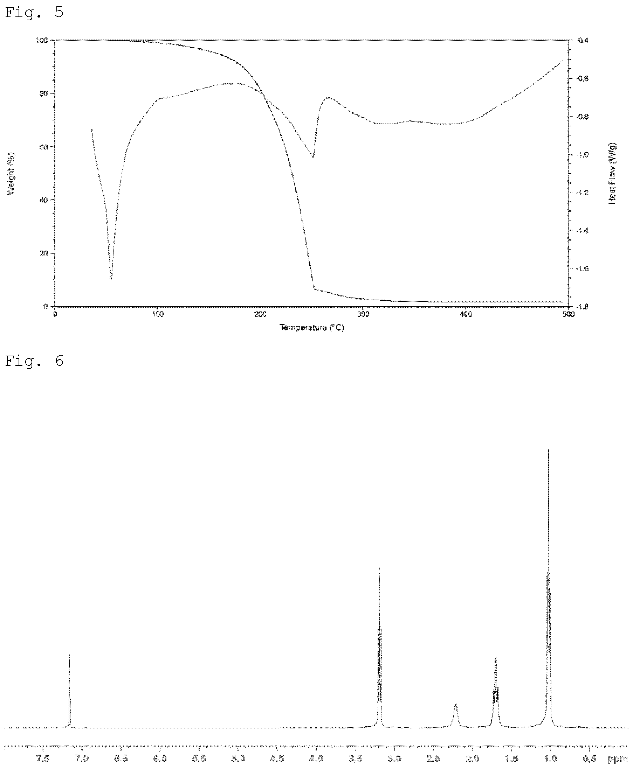

During TGA measurement (SDT Q600, purchased from TA instrument) performed at a temperature rise rate of 10°C/min in a nitrogen atmosphere at a flow rate of 200 mL/min, the pale yellow solid had a residual mass of 1.4%, indicating that there were almost no residues left. These results are shown in FIG. 5, which demonstrates TGA results showing the percentage of weight loss as a function of temperature changes.

### [Synthesis Example 3] Synthesis of tris-(di-n-propylethylamidinato)yttrium [Y(nPr₂Et-AMD)₃]

Into 300 mL of THF, 71.01 g (0.4609 mol) of di-n-propylethylamidinate was introduced, followed by cooling the resulting product to a temperature of -78°C, and 184.4 mL (0.4609 mol) of an n-BuLi hexane solution (2.5 M) was then slowly added dropwise to prepare Li-(nPr₂Et-AMD). The resulting solution was stirred at a temperature of -78°C for 30 minutes, heated to room temperature, and then stirred for an additional 2 hours at room temperature. The prepared Li-(nPr₂Et-AMD) solution was slowly added dropwise to a flask containing 30 g (0.4609 mol) of YCl₃ at a temperature of -78°C and then stirred at room temperature for 6 hours. The resulting mixture was evaporated under vacuum, dissolved in 200 mL of pentane, and filtered to evaporate the solvent and volatiles under vacuum to produce a yellow liquid, which was then distilled at a temperature of 221°C and a pressure of 42.6 mTorr to obtain a pale yellow solid. The yield was 55.30 g (64.9%). The analysis results of NMR (AV400MHz HD, purchased from Bruker) are as shown in FIG. 6, and the characteristic peaks obtained are as follows.

¹H NMR (C₆D₆, 25°C): 1.02(t, 9H), 1.71(q, 4H), 2.22(q, 2H), 3.18(q, 4H).

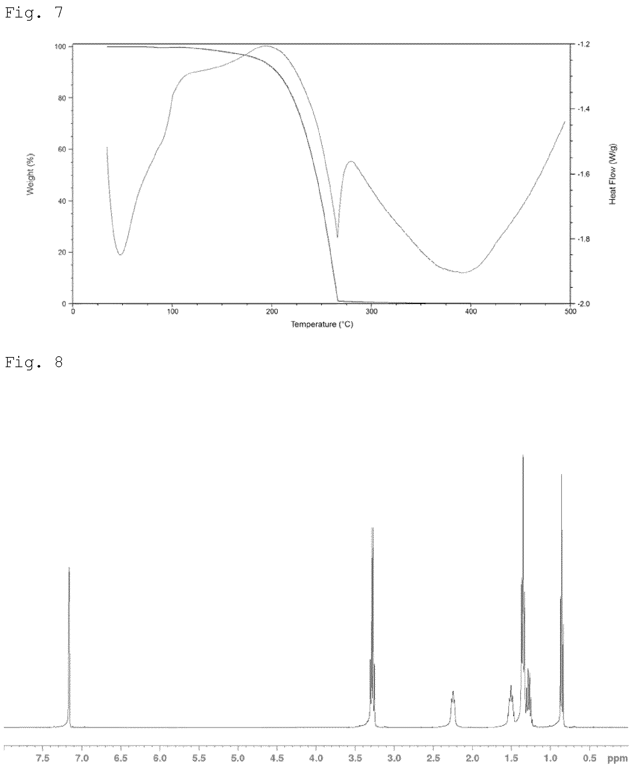

During TGA measurement (SDT Q600, purchased from TA instrument) performed at a temperature rise rate of 10°C/min in a nitrogen atmosphere at a flow rate of 200 mL/min, the pale yellow solid had a residual mass of 0.75%, indicating that there were almost no residues left. These results are shown in FIG. 7, which demonstrates TGA results showing the percentage of weight loss as a function of temperature changes.

### [Synthesis Example 4] Synthesis of tris-(diethyl-n-butylamidinato)yttrium [Y(Et₂nBu-AMD)₃]

Into 300 mL of THF, 120.05 g (0.7682 mol) of diethyl-n-butylamidinate was introduced, followed by cooling the resulting product to a temperature of -78°C, and 307.3 mL (0.7682 mol) of an n-BuLi hexane solution (2.5 M) was then slowly added dropwise to prepare Li-(Et₂nBu-AMD). The resulting solution was stirred at a temperature of -78°C for 30 minutes, heated to room temperature, and then stirred for an additional 2 hours at room temperature. The prepared Li-(Et₂nBu-AMD) solution was slowly added dropwise to a flask containing 30 g (0.2561 mol) of Ycl₃ at a temperature of -78°C and then stirred at room temperature for 6 hours. The resulting mixture was evaporated under vacuum, dissolved in 200 mL of pentane, and filtered to evaporate the solvent and volatiles under vacuum to produce an orange liquid, which was then distilled at a temperature of 210°C and a pressure of 141 mTorr to obtain a pale yellow liquid. The yield was 116.0 g (81.7%). The analysis results of NMR (AV400MHz HD, purchased from Bruker) are as shown in FIG. 8, and the characteristic peaks obtained are as follows.

¹H NMR (C₆D₆, 25°C): 0.850(t, 3H), 1.28(q, 2H), 1.35(t, 6H), 1.50(m, 2H), 2.25(m, 2H), 3.29(q, 4H).

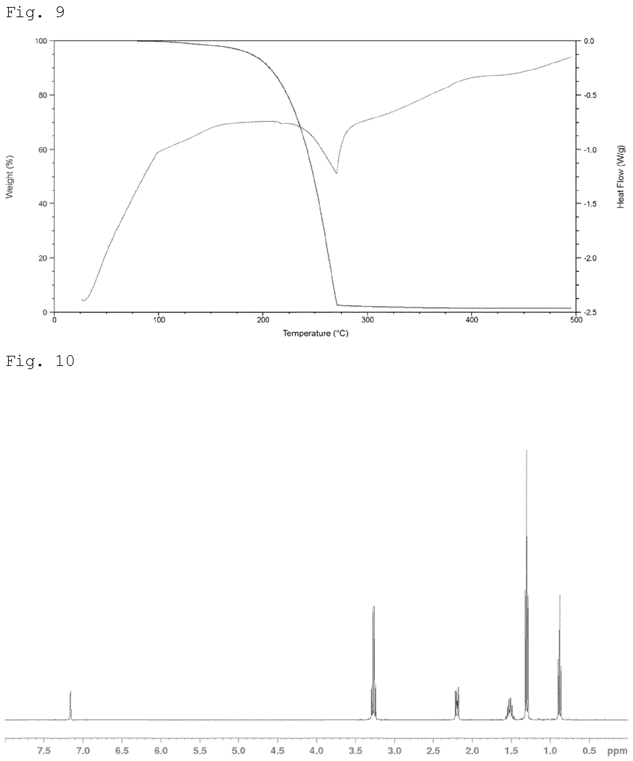

During TGA measurement (SDT Q600, purchased from TA instrument) performed at a temperature rise rate of 10°C/min in a nitrogen atmosphere at a flow rate of 200 mL/min, the pale yellow solid had a residual mass of 1.67%, indicating that there were almost no residues left. These results are shown in FIG. 9, which demonstrates TGA results showing the percentage of weight loss as a function of temperature changes.

### [Synthesis Example 5] Synthesis of tris-(diethyl-n-propylamidinato)scandium [Sc(Et₂nPr-AMD)₃]

Into 300 mL of THF, 58.79 g (0.3965 mol) of di-n-propylethylamidinate was introduced, followed by cooling the resulting product to a temperature of -78°C, and 158.61 mL (0.3965 mol) of an n-BuLi hexane solution (2.5 M) was then slowly added dropwise to prepare Li-(Et₂nPr-AMD). The resulting solution was stirred at a temperature of -78°C for 30 minutes, heated to room temperature, and then stirred for an additional 2 hours at room temperature. The prepared Li-(Et₂nPr-AMD) solution was slowly added dropwise to a flask containing 20 g (0.3965 mol) of ScCl₃ at a temperature of - 78°C and then stirred at room temperature for 6 hours. The resulting mixture was evaporated under vacuum, dissolved in 150 mL of pentane, and filtered to evaporate the solvent and volatiles under vacuum to produce a yellow liquid, which was then distilled at a temperature of 185°C and a pressure of 18.0 mTorr to obtain a pale yellow liquid. The yield was 56.80 g (78.6%). The analysis results of NMR (AV400MHz HD, purchased from Bruker) are as shown in FIG. 10, and the characteristic peaks obtained are as follows.

¹H NMR (C₆D₆, 25°C): 0.088 (t, 3H), 1.30 (t, 6H), 1.51 (q, 2H), 2.18(q, 2H), 3.26(q, 4H).

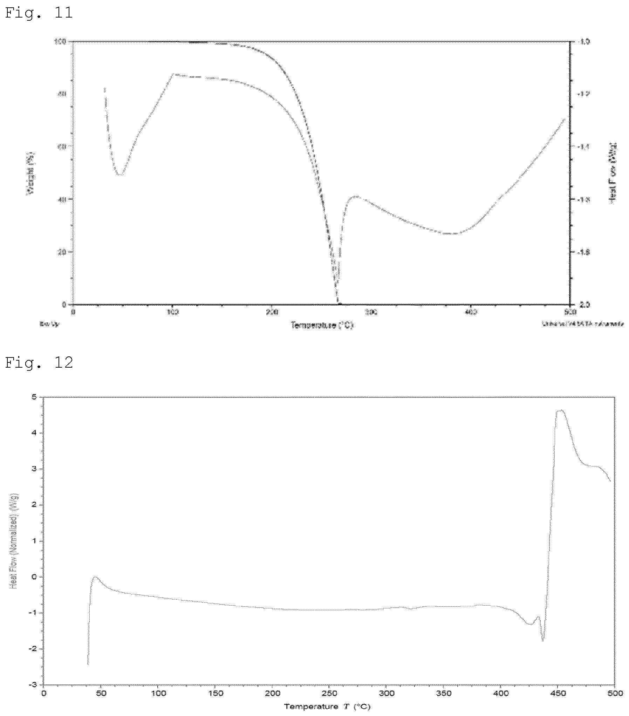

During TGA measurement (SDT Q600, purchased from TA instrument) performed at a temperature rise rate of 10°C/min in a nitrogen atmosphere at a flow rate of 200 mL/min, the pale yellow liquid had a residual mass of 0.19%, indicating that there were almost no residues left. These results are shown in FIG. 11, which demonstrates TGA results showing the percentage of weight loss as a function of temperature changes.

The pale yellow liquid sample was placed in a sealed container for DSC and kept under a temperature condition of 40°C for 10 minutes, followed by observing a decomposition peak at a temperature of 450°C during DSC analysis measurement (Discovery 25, purchased from TA instrument) performed at a temperature rise rate of 10°C/min. These results are shown in FIG. 12, which demonstrates DSC analysis results showing heat energy changes as a function of temperature changes.

### [Synthesis Example 6] Synthesis of tris-(diethylethylamidinato)scandium [Sc(Et₂Et-AMD)₃]

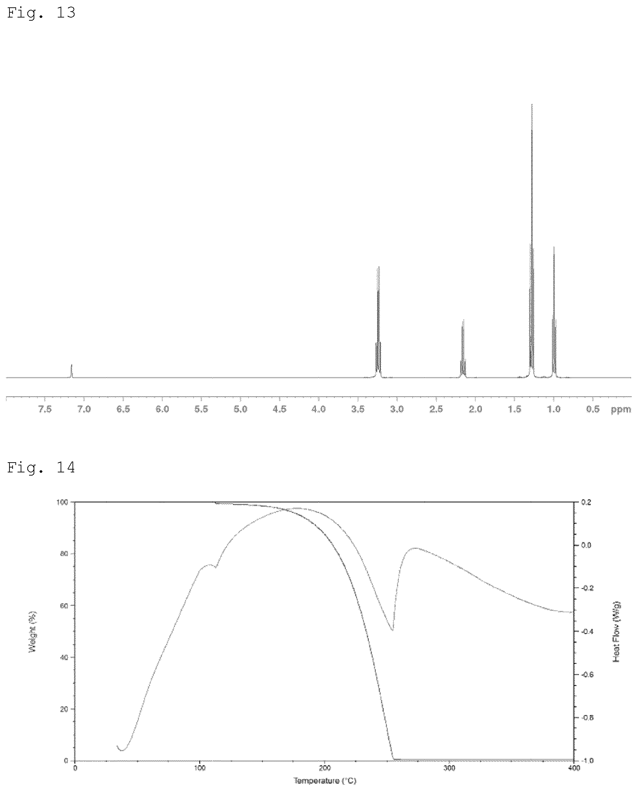

Into 300 mL of THF, 50.84 g (0.3965 mol) of diethylethylamidinate was introduced, followed by cooling the resulting product to a temperature of -78°C, and 158.6 mL (0.3965 mol) of an n-BuLi hexane solution (2.5 M) was then slowly added dropwise to prepare Li-(Et₂Et-AMD). The resulting solution was stirred at a temperature of -78°C for 30 minutes, heated to room temperature, and then stirred for an additional 2 hours at room temperature. The prepared Li-(Et₂Et-AMD) solution was slowly added dropwise to a flask containing 20 g (0.3965 mol) of ScCl₃ at a temperature of - 78°C and then stirred at room temperature for 6 hours. The resulting mixture was evaporated under vacuum, dissolved in 150 mL of pentane, and filtered to evaporate the solvent and volatiles under vacuum to produce a yellow liquid, which was then distilled at a temperature of 145°C and a pressure of 28.3 mTorr to obtain a pale yellow solid. The yield was 41.8 g (74.1%). The analysis results of NMR (AV400MHz HD, purchased from Bruker) are as shown in FIG. 13, and the characteristic peaks obtained are as follows.

¹H NMR (C₆D₆, 25°C): 0.99(t, 3H), 1.28(t, 6H), 2.15(q, 2H), 3.20(q, 4H).

During TGA measurement (SDT Q600, purchased from TA instrument) performed at a temperature rise rate of 10°C/min in a nitrogen atmosphere at a flow rate of 200 mL/min, the pale yellow solid had a residual mass of 0.3%, indicating that there were almost no residues left. These results are shown in FIG. 14, which demonstrates TGA results showing the percentage of weight loss as a function of temperature changes.

The analysis results of TGA measurement performed on the precursors according to Synthesis Examples 1 to 6 are shown in Table 1.

**[Table 1]**

| | Synthesis Example 1 | Synthesis Example 2 | Synthesis Example 3 | Synthesis Example 4 | Synthesis Example 5 | Synthesis Example 6 |
|---|---|---|---|---|---|---|
| TGA_{1/2} (°C) | 250 | 215 | 244.5 | 248.5 | 246.1 | 232 |

The analysis results of DSC measurement performed on the precursors obtained through Synthesis Examples 1, 3, and 5 are shown in Table 2.

**[Table 2]**

| | Synthesis Example 1 | Synthesis Example 3 | Synthesis Example 5 |
|---|---|---|---|
| DSC (°C) | 410 | 399 | 453 |

To confirm the viscosity of the precursors of Synthesis Examples 1 and 5, each sample was placed in a measurement container of a rotational viscometer (LVD2T, purchased from Brookfield) to measure viscosity using a spindle for low viscosity under a temperature condition of 25°C. The results thereof are shown in Table 3.

**[Table 3]**

| | Synthesis Example 1 | Synthesis Example 5 |
|---|---|---|
| Viscosity (cPs) | 48 | 36 |

Using the above precursor, a thin film formation process was performed as follows.

Using the precursor of Synthesis Example 1 and O₃ serving as an oxidant, film deposition evaluation was performed through an ALD process by a bubbler system. The film deposition evaluation was based on changes in thin film thickness as a function of the number of process cycles (number of cycles vs. thickness).

The precursor of Synthesis Example 1 was heated to the vaporization temperature, and argon (Ar) gas was then injected through a dip line to generate bubbles so that the vapor of the precursor compound being a gas was fed into a reaction chamber via a carrier gas.

To confirm changes in thin film thickness as a function of the number of process cycles by placing SiO₂ and TiN substrates in the reaction chamber while maintaining a set temperature (300°C), the deposition evaluation was performed under the following conditions: the precursor (60 seconds) - purge (80 seconds) - the oxidant (15 seconds) - purge (20 seconds).

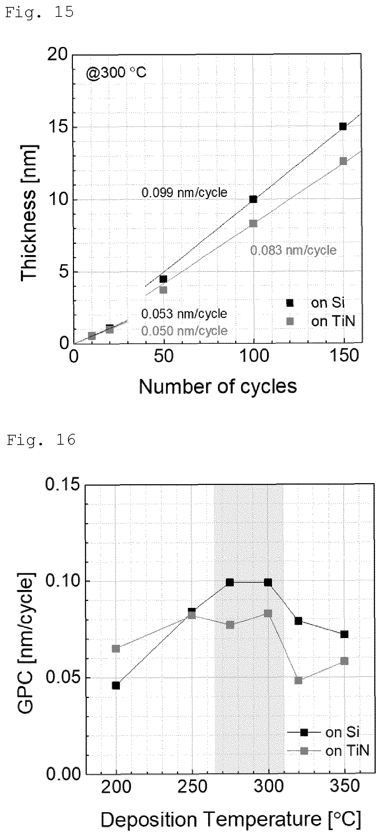

The purge process was performed using argon (Ar) gas at a flow rate of 700 sccm, and ozone (O₃), serving as the reactive gas, was injected at a concentration of 220 g/m³. The precursor was heated to a temperature of 80°C while injecting argon serving as the carrier gas at a flow rate of 200 sccm, and the number of process cycles performed was 50, 100, and 150. FIG. 15 shows the results of the changes in thin film thickness as a function of the number of deposition cycles in a process performed at a temperature of 300°C.

Referring to the results in FIG. 15, it is confirmed that for the SiO₂ and TiN specimens evaluated, the changes in thin film thickness as a function of the number of deposition cycles are uniform under the process temperature condition.

In addition, the deposition rates by substrates at a temperature of 300°C are shown in Table 4.

**[Table 4]**

| At 300°C | SiO₂ substrate | TiN substrate |
|---|---|---|
| Deposition rate (nm/cycle) | 0.099 | 0.083 |

In addition, to measure changes in deposition rates (ALD window) at a process temperature of 300°C, the precursor, according to Synthesis Example 3, was heated to the vaporization temperature, and argon (Ar) gas was then injected through a dip line to generate bubbles so that the vapor of the precursor compound being a gas was fed into a reaction chamber via a carrier gas.

To confirm changes in thin film deposition rates as a function of process temperatures by placing SiO₂ and TiN substrates in the reaction chamber while varying temperatures, the following processes were performed in an orderly manner: feeding of the precursor (60 seconds) - purge (80 seconds) - feeding of the oxidant (15 seconds) - purge (20 seconds). The purge process was performed using argon (Ar) gas at a flow rate of 700 sccm. Ozone (O₃), serving as the reactive gas, was injected at a concentration of 220 g/m³. The precursor was heated to a temperature of 80°C while injecting argon serving as the carrier gas at a flow rate of 200 sccm, and the number of process cycles was 50. FIG. 16 shows the results for the changes in thin film deposition rates as a function of the process temperatures.

Referring to the results in FIG. 16, the thin film deposition rates (nm/cycle) appeared to be similar at the process temperatures of 275°C and 300°C. Through this, it is seen that the process temperature range (ALD window) is obtained.

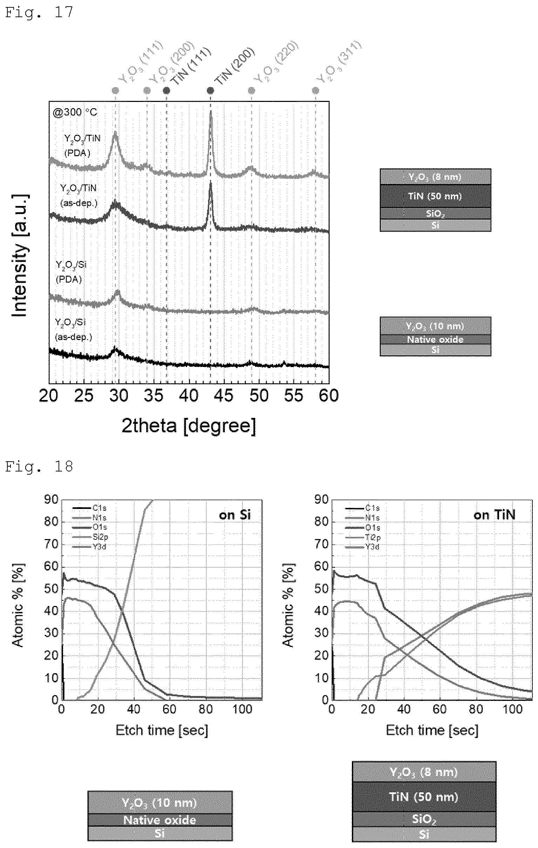

In addition, to confirm thin film crystallinity by process temperatures, XRD analysis was performed on the Y₂O₃ thin films obtained on the SiO₂ and TiN specimens by process temperatures through the above process evaluation. As a result, the crystallinity of the thin films was confirmed. The crystallinity was measured after the deposition process, and analysis was also performed on specimens obtained after heat treatment using rapid thermal annealing (RTA) under a N₂ atmosphere condition at a temperature of 600°C for 30 seconds. As a result of the analysis, the cubic-phase crystallinity of Y₂O₃ was confirmed in the thin film deposited under the temperature condition of 300°C among the thin films obtained immediately after deposition. Furthermore, it was found that a greater degree of the cubic-phase crystallinity of Y₂O₃ was formed after the heat treatment. The analyzed XRD results are shown in FIG. 17.

In addition, XPS depth profiles were analyzed to confirm the composition and impurities of the thin film. Through XPS analysis performed on the Y₂O₃ thin films deposited onto the SiO₂ and TiN specimens at a temperature of 300°C, the composition and impurity content of the thin films were confirmed. Both contents of C and N impurities in the thin films were confirmed to be 0%. In terms of the O/Y content ratio, it was confirmed that the O/Y composition ratio was 1.19 in the SiO₂ substrate, and the O/Y composition ratio was 1.26 in the TIN substrate. The analyzed results of the XPS depth profiles are shown in FIG. 18.

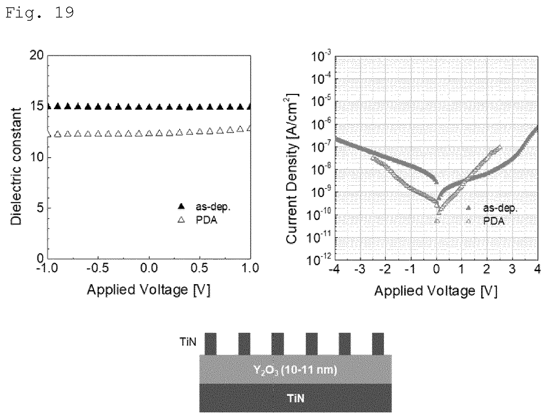

In addition, to confirm the electrical properties of the thin film, TiN was deposited as a top electrode onto the deposited thin film, followed by measuring the dielectric constant and current density. The results thereof are shown in Table 5 and FIG. 19.

**[Table 5]**

| | Dielectric constant at 0 V | Current density [A/cm²] at +0.8 V | Current density [A/cm²] at -0.8 V |
|---|---|---|---|
| As-dep | 14.89 | 2.30E-9 | 1.15E-8 |
| PDA | 12.32 | 1. 01E-9 | 1.07E-9 |

From the above results, it was confirmed that the use of the precursor for forming the thin film of the present disclosure enabled a high-quality scandium- or yttrium-containing thin film to be formed.

The present disclosure has been described above with reference to preferred embodiments but is not limited to these embodiments. Various modifications and changes may be made by those skilled in the art to which the present disclosure belongs without departing from the spirit of the present disclosure. Such modifications and changes should be construed as falling within the scope of the present disclosure and the appended claims.

## Claims

1. A precursor for forming a scandium- or yttrium-containing thin film, the precursor comprising a scandium- or yttrium-containing compound represented by Chemical Formula 1 below, 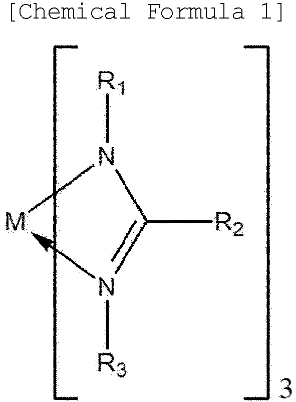 wherein in Chemical Formula 1,
M is a scandium or yttrium metal, R₁ and R₃ are each independently a straight-chain, branched-chain, or cyclic alkyl or alkenyl group having 1 to 5 carbon atoms, and R₂ is a hydrogen atom or a straight-chain, branched-chain, or cyclic alkyl or alkenyl group having 1 to 6 carbon atoms.

2. The precursor of claim 1, wherein in Chemical Formula 1, R₂ is a straight-chain, branched-chain, or cyclic alkyl or alkenyl group having 2 to 4 carbon atoms.

3. The precursor of claim 1, wherein in Chemical Formula 1, R₁ and R₃ are each independently a straight-chain, branched-chain, or cyclic alkyl or alkenyl group having 2 to 5 carbon atoms, and R₂ is a straight-chain, branched-chain, or cyclic alkyl or alkenyl group having 2 to 4 carbon atoms.

4. The precursor of claim 1, wherein in Chemical Formula 1, R₁ and R₃ are methyl groups.

5. The precursor of claim 1, wherein in Chemical Formula 1, R₂ is an isopropyl group.

6. The precursor of claim 1, wherein in Chemical Formula 1, R₁ and R₃ are each independently a straight-chain alkyl or alkenyl group having 1 to 5 carbon atoms.

7. The precursor of claim 1, wherein in Chemical Formula 1, R₁ and R₃ are each independently a straight-chain alkyl or alkenyl group having 1 to 5 carbon atoms, and R₂ is a straight-chain alkyl or alkenyl group having 1 to 4 carbon atoms.

8. The precursor of claim 1, wherein in Chemical Formula 1, R₁ and R₃ are both the same and are straight-chain, branched-chain, or cyclic alkyl or alkenyl groups having 1 to 5 carbon atoms.

9. The precursor of claim 1, wherein in Chemical Formula 1, R₁ to R₃ are all the same and are straight-chain, branched-chain, or cyclic alkyl or alkenyl groups having 1 to 4 carbon atoms.

10. The precursor of claim 1, wherein the precursor has a viscosity of 60 cP or less.

11. The precursor of claim 1, wherein the precursor has a melting point of 70°C or lower.

12. The precursor of claim 1, further comprising a solvent.

13. The precursor of claim 12, wherein the solvent is one or more of a saturated or unsaturated hydrocarbon having 1 to 16 carbon atoms, a ketone, an ether, glyme, an ester, tetrahydrofuran (THF), and a tertiary amine.

14. The precursor of claim 12, wherein the solvent is included in an amount range of 1 to 99 wt% with respect to the total weight of the precursor.

15. The precursor of claim 1, wherein the compound is at least one selected from the group consisting of the following chemical structures.

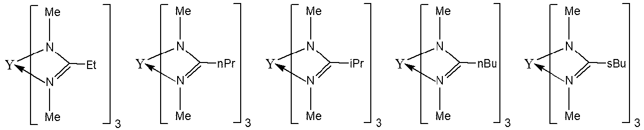

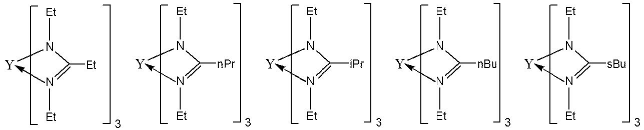

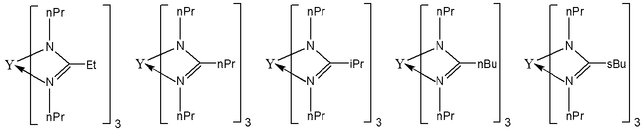

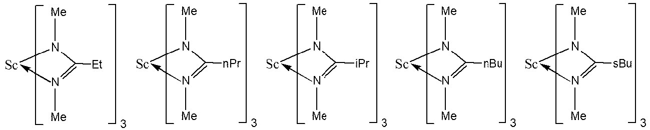

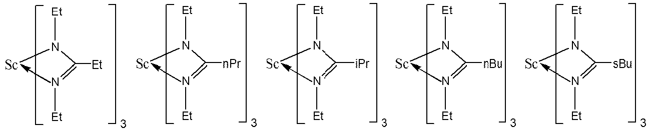

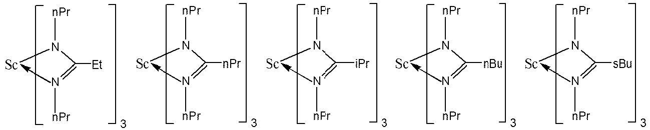

16. A method for forming a scandium- or yttrium-containing thin film, the method comprising a process of forming a thin film on a substrate using the precursor of claim 1 or 12.

17. The method of claim 16, wherein the process of forming the thin film on the substrate comprises:
a process of forming a precursor thin film through deposition of the precursor onto the surface of the substrate; and
a process of reacting the precursor thin film with a reactive gas.

18. The method of claim 17, wherein the process of forming the precursor thin film comprises a process of vaporizing the precursor to transfer the resulting vapor of the precursor into a chamber.

19. The method of claim 17, wherein the deposition is performed by any one process of spin-on dielectric (SOD) deposition, low-temperature plasma (LTP) deposition, chemical vapor deposition (CVD), plasma enhanced chemical vapor deposition (PECVD), high-density plasma chemical vapor deposition (HDPCVD), atomic layer deposition (ALD), or plasma enhanced atomic layer deposition (PEALD).

20. The method of claim 16, wherein the process of forming the thin film on the substrate comprises feeding the precursor onto the substrate and applying a plasma, thereby forming the thin film.

21. A semiconductor device comprising a scandiumor yttrium-containing thin film manufactured by the method of claim 16.
